(19) Europäisches Patentamt
European Patent Office
Office européen des brevets

(11) EP 0 662 222 B1

(12) **EUROPEAN PATENT SPECIFICATION**

(45) Date of publication and mention of the grant of the patent:
**22.01.1997 Bulletin 1997/04**

(21) Application number: **93922386.3**

(22) Date of filing: **24.09.1993**

(51) Int Cl.[6]: **G03F 7/023**

(86) International application number:
**PCT/US93/09120**

(87) International publication number:
**WO 94/08275 (14.04.1994 Gazette 1994/09)**

# (54) POSITIVE-WORKING PHOTORESIST COMPOSITION

POSITIV ARBEITENDE PHOTOLACKZUSAMMENSETZUNG

COMPOSITION DE PHOTORESERVE TRAVAILLANT EN POSITIF

(84) Designated Contracting States:
**DE FR GB IT**

(30) Priority: **28.09.1992 US 952451**

(43) Date of publication of application:
**12.07.1995 Bulletin 1995/28**

(73) Proprietors:
- **HOECHST CELANESE CORPORATION**
  **Somerville, N.J. 08876 (US)**
- **INTERNATIONAL BUSINESS MACHINES CORPORATION**
  **Armonk, N.Y. 10504 (US)**

(72) Inventors:
- **LU, Ping-Hung**
  **Edison, NJ 08820 (US)**
- **DAMMEL, Ralph R.**
  **Coventry, RI 02716 (US)**
- **EIB, Nicholas Kiser**
  **Hopewell Junction, NY 12533 (US)**
- **FICNER, Stanley A.**
  **Bethlehem, PA 18017 (US)**
- **KHANNA, Dinesh N.**
  **East Greenwich, RI 02818 (US)**
- **KLOFFENSTEIN, Thomas J., Jr.**
  **Belle Mead, NJ 08512 (US)**
- **LYONS, Christopher F.**
  **Freemount, CA 94539 (US)**
- **PLAT, Marina**
  **Hyde Park, NY 12538 (US)**
- **RAHMAN, M. Dalil**
  **Warwick, RI 02886 (US)**

(74) Representative:
**De Minvielle-Devaux, Ian Benedict Peter et al**
**CARPMAELS & RANSFORD**
**43, Bloomsbury Square**
**London WC1A 2RA (GB)**

(56) References cited:

| | |
|---|---|
| **EP-A- 0 365 318** | **FR-A- 2 109 715** |
| **US-A- 4 797 346** | **US-A- 4 988 601** |

- **IBM TECHNICAL DISCLOSURE BULLETIN. vol. 25, no. 8 , January 1983 , NEW YORK US pages 4401 - 3 L.P. BUSHNELL ET AL. 'mixed-resin photoresist system for mid and deel ultraviolet'**
- **DATABASE WPI Week 7730, Derwent Publications Ltd., London, GB; AN 7753080Y & JP,A,52 071 224 (OKYO SHIBAURA ELEC LTD) 14 June 1977**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

### BACKGROUND OF THE INVENTION

The present invention relates to positive photoresist compositions which are especially sensitive in the i-line range of the spectrum, containing a mixture of alkali soluble novolak resins having different dissolution rates and to a process for producing such photoresist compositions. The present invention also relates to a process for producing semiconductor devices using such a positive photoresist composition by coating suitable substrates with these photoresist compositions, as well as the process of coating, imaging and developing photoresists on suitable substrates and to semiconductor devices produced using such processes.

Photoresist compositions are used in microlithography processes for making miniaturized electronic components such as in the fabrication of computer chips and integrated circuits. Generally, in these processes, a thin coating of a film of a photoresist composition is first applied to a substrate material, such as silicon wafers used for making integrated circuits. The coated substrate Is then baked to evaporate solvent in the photoresist composition and to fix the coating onto the substrate. The baked coated surface of the substrate is next subjected to an image-wise exposure to radiation.

This radiation exposure causes a chemical transformation in the exposed areas of the coated surface. Visible light, ultraviolet (UV) light, electron beam and X-ray radiant energy are radiation types commonly used today in microlithographic processes. After this image-wise exposure, the coated substrate is treated with a developer solution to dissolve and remove either the radiation-exposed or the unexposed areas of the coated surface of the substrate.

Novolak resins are frequently used as a polymeric binder in liquid photoresist formulations. These resins are typically produced by conducting a condensation reaction between formaldehyde and one or more multisubstituted phenols, in the presence of an acid catalyst, such as oxalic acid. There are two types of photoresist compositions, negative-working and positive-working. When negative-working photoresist compositions are exposed image-wise to radiation, the areas of the resist composition exposed to the radiation become less soluble to a developer solution (e.g, a cross-linking reaction occurs) while the unexposed areas of the photoresist coating remain relatively soluble to such a solution. Thus, treatment of an exposed negative-working resist with a developer causes removal of the non-exposed areas of the photoresist coating and the creation of a negative image in the coating. Thereby uncovering a desired portion of the underlying substrate surface on which the photoresist composition was deposited.

On the other hand, when positive-working photoresist compositions are exposed image-wise to radiation, those areas of the photoresist composition exposed to the radiation become more soluble to the developer solution (e.g. a rearrangement reaction occurs) while those areas not exposed remain relatively insoluble to the developer solution. Thus, treatment of an exposed positive-working photoresist with the developer causes removal of the exposed areas of the coating and the creation of a positive image in the photoresist coating. Again, a desired portion of the underlying substrate surface is uncovered.

After this development operation, the now partially unprotected substrate may be treated with a substrate-etchant solution or plasma gases and the like. The etchant solution or plasma gases etch that portion of the substrate where the photoresist coating was removed during development. The areas of the substrate where the photoresist coating still remains are protected and, thus, an etched pattern is created in the substrate material which corresponds to the photomask used for the image-wise exposure to the radiation. Later, the remaining areas of the pohotoresist coating may be removed during a stripping operation, leaving a clean etched substrate surface. In some instances, it is desirable to heat treat the remaining photoresist layer, after the development step and before the etching step, to increase its adhesion to the underlying substrate and its resistance to etching solutions.

Positive working photoresist compositions are currently favored over negative working resists because the former generally have better resolution capabilities and pattern transfer characteristics. Photoresist resolution is defined as the smallest feature which the resist composition can transfer from the photomask to the substrate with a high degree of image edge acuity after exposure and development. In many manufacturing applications today, resist resolution on the order of less than one micron are necessary. In addition, it is almost always desirable that the developed photoresist wall profiles be near vertical relative to the substrate. Such demarcations between developed and undeveloped areas of the resist coating translate into accurate pattern transfer of the mask image onto the substrate.

US-A-4 988 601 discloses a mixture of a 2,5-xylenol/cresol novolak with a 3,5-xylenol/cresol novolak wherein the solubility characteristics with respect to an alkaline developing agent are largely different from each other.

### SUMMARY OF THE INVENTION

The prior art discloses photoresist compositions which contain mixtures of two novolak resins with the same composition, but with different molecular weights. Because the molecular weight distribution in these resins consists of two different sub-distributions of molecular weight, such resins have been characterized as bimodal.

The present invention relates to the surprising discovery that an improved photoresist composition is obtained by

utilizing a mixture of resins having similar molecular weights and similar molecular weight distributions, but each having a different dissolution rate. Although there is no known method for measuring dissolution rate distribution in a manner which is analogous to molecular weight distribution, the resins of the present invention may be characterized as Bimodal Dissolution Rate (BDR) resins. BDR resins are defined as resins having the following characteristics:

a) a film forming resins useful for photoresist compositions;
b) comprising a mixture of at least two resins, with the same or different chemical composition, for which the molecular weight distribution of the two component resins, normalized to the same area, show an overlap of at least fifty percent (50%), preferably 60-100%, more preferably 70-95%, and for which the dissolution rates of the two component resins differ by a factor of at least 2.0, preferably 2.0 to about 6.0, most preferably 2.5 to about 4.5.

In formulating the BDR resins of the present invention, two or more of the following resins, which do not meet the criteria for a BDR resin, may be utilized: 1) any resins which are the products of a polycondensation reaction between one or more phenolic monomers and formaldehyde, or 2) a mixture of such reaction products. Molecular weight and molecular weight distribution, as used above, are defined via a GPC versus polystyrene standard, not as absolute values.

The mixture of phenolic monomer(s)/formaldehyde resins enables one to formulate the photoresist compositions of the present Invention which display improved, or at least equivalent, thermal stabiliy when compared to a photoresist composition formulated using only the component resin having the higher thermal stability. The photoresist compositions of the present invention display improved thermal stability when compared to a photoresist composition formulated using the component resin having the lower thermal stability.

The photoresist compositions of the present invention also provide semiconductor devices having a very good pattern profile, a low degree of scumming, no standing wave and very good depth of focus. They also provide a wide process window when producing semiconductor devices.

The present invention relates to radiation sensitive positive working photoresist compositions and particularly to photoresist compositions containing a mixture of novolak resins having different dissolution rates. The invention further relates to a process for producing semiconductor devices using such photoresist compositions.

The subject invention provides a liquid, positive photoresist comprising an admixture of:

a) a photosensitive component in an amount sufficient to uniformly photosensitize the photoresist composition;
b) a water insoluble, aqueous alkali soluble film forming novolak resin in an amount sufficient to form a substantially uniform photoresist composition, the novolak resin comprising a mixture of at least two novolak resins, with the same or different chemical compostion, for which the molecular weight distribution of the component resins, normalized to the same area, show an overlap of at least fifty percent (50%) and for which the dissolution rates of the component resins differ by a factor of at least 2.0; and
c) a suitable solvent.

The present invention provides a process for formulating a photoresist composition solution by providing an admixture of:

1) a photosensitive component in an amount sufficient to uniformly photosensitize the photoresist composition;
2) a water insoluble, aqueous alkali soluble film forming novolak resin In an amount sufficient to form a substantially uniform photoresist composition, the novolak resin comprising a mixture of at least two novolak resins, with the same or different chemical composition, for which the molecular weight distribution of the component resins, normalized to the same area, show an overlap of at least fifty percent (50%) and for which the dissolution rates of the component resins differ by a factor of at least 2.0; and
3) a suitable solvent.

The invention further provides a method for producing a semiconductor device by producing a photo-image on a substrate by coating a suitable substrate with a photoresist composition solution by:

a) formulating a photoresist composition solution by providing an admixture of:

1) a photosensitive component in an amount sufficient to photosensitize the photoresist composition,
2) a water insoluble, aqueous alkali soluble film forming novolak resin in an amount sufficient to form a substantially uniform photoresist composition, the novolak resin comprising a mixture of at least two novolak resins, with the same or different chemical composition, for which the molecular weight distribution of the component resins, normalized to the same area, show an overlap of at least fifty percent (50%) and for which the dissolution

rates of the component resins differ by a factor of at least 2.0, and
3) a suitable solvent;

b) coating a suitable substrate with the photoresist composition;
c) heat treating the coated substrate until substantially all of the solvent is removed; image-wise exposing the photosensitive composition and removing the image-wise exposed areas of such composition with a suitable developer, such as an aqueous alkaline developer. Optionally one may perform a baking of the substrate either immediately before or after the removing step.

The invention also relates to a semiconductor devices produced by providing photo-image on a substrate by coating a suitable substrate with a photoresist composition solution by:

a) formulating a photoresist composition solution by providing an admixture of:

1) a photosensitive component in an amount sufficient to photosensitize the photoresist composition,
2) a water insoluble, aqueous alkali soluble film forming novolak resin in an amount sufficient to form a substantially uniform photoresist composition, the novolak resin comprising a mixture of at least two novolak resins, with the same or different chemical composition, for which the molecular weight distribution of the component resins, normalized to the same area, show an overlap of at least fifty percent (50%) and for which the dissolution rate of the component resins differ by a factor of at least 2.0, and
3) a suitable solvent;

b) coating a suitable substrate with the photoresist composition;
c) heat treating the coated substrate until substantivity all of the solvent is removed; image-wise exposing the photosensitive composition and removing the image-wise exposed areas of such composition with a suitable developer, such as an aqueous alkaline developer. Optionally one may perform a baking of the substrate either immediately before or after the removing step.

## Detailed Description of the Preferred Embodiments

Novolak resins have been commonly used in the art of photoresist manufacture as exemplified by "Chemistry and Application of Phenolic Resins", Knop A, and Scheib, W.; Springer Verlag, New York, 1979 in Chapter 4. Similarly, o-quinone diazides are well known to the skilled artisan as demonstrated by "Light Sensitive Systems", Kosar, J.; John Wiley & Sons, New York, 1985 Chapter 7.4. These resins are typically produced by conducting a condensation reaction between formaldehyde and one or more multisubstituted phenols, in the presence of an acid catalyst, such as oxalic acid.

Suitable multi-substituted phenols are well known in the prior art and include meta-cresol, para-cresol and 3,5-xylenol.

The sensitizer which comprises a component of the photoresist composition of the present invention may be an ester of a multihydroxy phenolic or alcoholic compound, such as a tris-hydroxyphenylethane (THPE) or a hydroxybenzophenone, and a sulfonic acid or sulfonic acid derivative such as a sulfonyl chloride, such as described in U.S. Patents 3,106,485 and 4,719,167, which are incorporated herein by reference. The sensitizer preferably has its hydroxy groups partically esterified by reacting from about 30 to about 100 percent of the hydroxy groups with one or more organic acid group containing compounds. The organic acid group containing compounds are preferably organic acid chlorides such as sulfonyl chlorides including 4-chloro benzene sulfonyl chloride, 4-methane sulfonyl chloride, para-toluene sulfonyl chloride, trifluoromethane sulfonyl chloride, 1,2-naphthoquinone diazide-4-sulfonyl chloride (F-sulfonyl chloride), 1,2-naphthaquinone diazide-5-sulfonyl chloride (L-sulfonyl chloride); acetyl chloride or benzoyl chloride.

The photosensitizer preferably contains between 25 and 100%, more preferably between 50 and 100%, most preferably between 70 and 100%, of an esterification product of a quinone diazide, preferentially a 2,1-diazonaphthoquinone derivative, most preferentially a 2,1-diazonaphtoquinone-5-sulfonate, a 2,1-diazonaphthoquinone-4-sulfonate, a 2,1-diazonaphthoquinone-6-sulfonate, or a 7-methoxy-substituted 2,1-diazonaphthoquinone-4-sulfonate, or any mixture thereof, with a degree of esterification ranging from 30 to 100%, preferably from 60 to 100%, most preferably from 85 to 100%.

In a more preferred embodiment, the photosensitizer is a polyhydroxysubstituted aromatic compound of formula I, or a mixture of compounds of formula I.

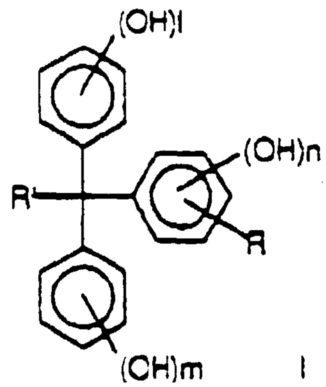

I

where l, m and n are numbers in the range of 0 to 3 inclusive; and where, if n > 0, R = hydrogen, alkyl (e.g. $C_1$ to $C_5$ alkyl), aryl (e.g. phenyl, naphthyl) or alkylaryl (e.g. $C_1$ to $C_5$ alkyl substituted phenyl or naphthyl); and where, if n = 0, R = hydrogen, alkyl (e.g. $C_1$ to $C_5$ alkyl), hydroxyaryl (e.g. phenyl, naphthyl), preferably monohydroxyaryl, most preferably 4-hydroxyphenyl), alkylaryl (e.g. $C_1$ to $C_5$ alkylphenyl or alkylnaphthyl), preferably hydroxysubstituted and bound to the aromatic ring by a methylene, a 1-ethylidene or 2-isopropylidene bridge, most preferably 4-hydroxyphenyl-2-isopropylidene, -1-ethylidene or methylene; and where R' is hydrogen, alkyl (e.g. $C_1$ to $C_5$ alkyl), or cycloalkyl (e.g. $C_1$ to $C_5$ cycle, $C_1$ to $C_5$ alkyl).

The photoresist composition is formed by blending the ingredients in a suitable solvent. In the preferred embodiment, the amount of novolak resin in the photoresist preferably ranges from 70% to about 90% and more preferably from about 75% to about 85% based on the weight of the solid; i.e., non-solvent photoresist components. In the preferred embodiment, the photosensitizer is present in the photoresist in an amount of from about 10% to about 30% preferably from about 15% to about 25%, based on the weight of the solids photoresist components.

Suitable solvents for such photoresists may include propylene glycol mono-alkyl ether, propylene glycol alkyl (e. g. methyl) ether acetate, ethyl-3-ethoxypropionate, ethyl lactate, mixtures of ethyl-3-ethoxypropionate and ethyl lactate, butyl acetate, xylene, diglyme, ethylene glycol monoethyl ether acetate. The preferred solvents are propylene glycol methyl ether acetate (PGMEA) and ethyl-3-ethoxypropionate (EEP).

Other optional ingredients such as colorants, dyes, anti-striation agents, leveling agents, plasticizers, adhesion promoters, speed enhancers, solvents and such surfactants as non-ionic surfactants may be added to the solution of novolak resin, sensitizer and solvent before the photoresist composition is coated onto a substrate.

The skilled artisan will know that dyes are often selected which absorb strongly at a wavelength corresponding to the wavelength of light used in one or more lithographic process steps, and particularly corresponding to the wavelength of the exposing radiation.

Examples of dye additives that may be used together with the photoresist compositions of the present invention include Methyl Violet 28 (C.I. No. 42535), Crystal Violet (C.I. 42555), Malachite Green (C.I. No. 42000). Victoria Blue B (C.I. No. 44045), Neutral Red (C.I. No. 50040), Sudan Orange (C.I, 11920), Curcumin (C.A.S. Reg. No. 458.37-7), Coumarin 1 (C.A.S, Reg. No. 91.44-1), Coumarin 7 (C.A.S. Reg. No. 27425-55-4), Coumarin 314 (C.A.S. Reg. No. 55804-66-5), Disperse Yellow 9 (C.I. 10375), Alizarin Yellow GG (C.I. 14025), Alizarin Yellow R (C.I. 14030), Basic Yellow 1 (C.I. 49005), and 3,3'-carbonylbis (7-diethylaminocoumarin) (C.A.S. Reg. No. 63226-13-1) at one to ten percent weight levels, based on the combined weight of novolak and sensitizer. The dye additives help provide increased resolution by inhibiting back scattering of light off the substrate.

Anti-striation agents may be used at up to about a five percent weight level, based on the combined weight of film forming resin and sensitizer. Plasticizers which may be used include, for example, phosphoric acid tri-(beta-chloroethyl)-ester; stearic acid; dicamphor; acetal resins; phenoxy resins; and alkyl resins, at about one to ten percent weight levels, based on the combined weight of film forming resin and sensitizer. The plasticizer additives improve the coating properties of the material and enable the application of a film that is smooth and of uniform thickness to the substrate. Adhesion promoters which may be used include, for example, beta-(3,4-epoxy-cyclohexyl)-ethyltrimethoxysilane; p-methyl-disiiane-methyl methacrylate; vinyltrichlorosilane; and gamma-amino-propyl triethoxysilane up to about a 4 percent weight level, based on the combined weight of film forming resin and sensitizer. Development speed enhancers that may be used include, for example, pioric acid, nicotinic acid or nitrocinnamic acid up to about a 20 percent weight level, based on the combined weight of film forming resin and sensitizer. These enhancers tend to increase the solubility of the photoresist coating in both the exposed and unexposed areas, and thus they are used in applications when speed of development is the overriding consideration even though some degree of contrast may be sacrificed; i.e., while the exposed areas of the photoresist coating will be dissolved more quickly by the developer, the speed enhances will also cause a larger loss of photoresist coating from the unexposed areas.

The solvents may be present in the overall composition in an amount of up to 95% by weight of the photoresist composition. Solvents, of course are substantially removed after coating of the photoresist solution on a substrate and drying.

The prepared photoresist composition solution, can be applied to a substrate by any conventional method used in the photoresist art, including dipping, spraying, whirling and spin coating. When spin coating, for example, the resist solution can be adjusted with respect to the percentage of solids content, in order to provide a coating of the desired thickness, given the type of spinning equipment utilized and the amount of time allowed for the spinning process. Suitable substrates include silicon, aluminum, polymeric resins, silicon dioxide, doped silicon dioxide, silicon nitride, tantalum, copper, polysilicon, ceramics, aluminum/copper mixtures; gallium arsenide and other such Group III/V compounds.

The photoresist coatings produced by the described procedure are particularly suitable for application to thermally grown silicon/silicon dioxidecoated wafers, such as are utilized in the production of microprocessors and other miniaturized integrated circuit components. An aluminum/aluminum oxide wafer can also be used. The substrate may also comprise various polymeric resins, especially transparent polymers such as polyesters. The substrate may have an adhesion promoted layer of a suitable composition, such as one containing hexa-alkyl disilazane.

The photoresist composition solution is then coated onto the substrate, and the substrate is treated at a temperature from about 70°C to about 120°C for from about 30 seconds to about 180 seconds on a hot plate or for from about 15 to about 90 minutes in a convection oven (Soft Bake). This temperature treatment is selected in order to reduce the concentration of residual solvents in the photoresist, while not causing substantial thermal degradation of the photosensitizer. In general, one desires to minimize the concentration of solvents and this first temperature treatment is conducted until substantially all of the solvents have evaporated and a thin coating of photoresist composition, on the order of one micron in thickness, remains on the substrate. In a preferred embodiment the treatment temperature is from about 90°C to about 120°C. The treatment is conducted until the rate of change of solvent removal becomes relatively insignificant. The temperature and time selection depends on the photoresist properties desired by the user, as well as the equipment used and commercially desired coating times. The coating substrate can then be exposed to actinic radiation, e.g., ultraviolet radiation, at a wavelength of from about 300 nm to about 450 nm, x-ray, electron beam, ion beam or laser radiation, in any desired pattern, produced by use of suitable masks, negatives, stencils, templates, etc.

The photoresist is then optionally subjected to a post exposure second baking or heat treatment (PEB) either before or after development. The heating temperatures may range from about 80°C to about 120°C, more preferably from about 90°C to about 120°C. The heating may be conducted for from about 30 seconds to about 2 minutes, more preferably from about 60 seconds to about 90 seconds on a hot plate or about 30 minutes to about 45 minutes in a convection oven.

The exposed photoresist-coated substrates are developed to remove the image-wise exposed areas by immersion in an alkaline developing solution or developed by spray development process. The solution is preferably agitated, for example, by nitrogen burst agitation. The substrates are allowed to remain in the developer until all, or substantially all, of the photoresist coating has dissolved from the exposed areas. Developers may include aqueous solutions of ammonium or alkali metal hydroxides. One preferred hydroxide is tetramethyl ammonium hydroxide. After removal of the coated wafers from the devoloping solution, one may conduct an optional post-development heat treatment or bake to increase the coating's adhesion and chemical resistance to etching solutions and other substances. The post-development heat treatment can comprise the oven baking of the coating and substrate below the coating's softening point. In Industrial application, particularly in the manufacture of microcircuitry units on silicon/silicon dioxide-type substrates, the developed substrates may be treated with a buffered, hydrofluoric acid base etching solution. The photoresist compositions of the present invention are resistant to acid-base etching solutions and provide effective protection for the unexposed photoresist-coating areas of the substrate.

The following specific examples will provide detailed illustrations of the methods of producing and utilizing compositions of the present invention. These examples are not intended, however, to limit or restrict the scope of the invention in any way and should not be construed as providing conditions, parameters or values which must be utilized exclusively in order to practice the present invention.

Example 1

Synthesis of Novolak Resin using m-cresol and 3,5-xylenol (6,23:3 Ratio);

Into a two liter four necked flask equipped with a thermometer, stirring shaft, condenser and a dropping funnel were added 162.12 grams (1.5 moles) meta-cresol, 88.23 grams (0.722 moles) 3,5-Xylenol, 170 grams dipropylene glycol methyl ether (DPGME) solvent and 0.625 grams oxalic acid (about 0.25% by weight of total phenols). The flask was heated slowly from room temperature using a heating mantle controlled by a thermo-watch. The contents of the

flask were gently stirred. The reaction contents were heated to 95°C and when the temperature was stablized at 95°C, 126 grams (37.28%) formaldehyde solution was adder by dropping funnel over a period of 90 minutes. The cresol: formaldehyde ratio was 1:0.7. The condensation was then carried out at 95°C for six hours. After condensation at 95°C, the distillation was carried out at atmospheric pressure to remove water. The temperature was increased up to 200°C and excess cresol and solvent were removed under 4665 PA vaccum (35 mm Hg) at a temperature from 200 to 220°C. The vaccum was released at 220°C and the molten resin was poured into an aluminum pan. The resin obtained had a viscosity of 10.7 (7.0% solution in Cyclohexanone), a Glass transition Temperature (Tg = 105°C), Dissolution Rate = 1.8 to 2.7 micrometers (microns)/minute using 2.38% Tetra Methyl Ammonium Hydroxide (TMAH) AZ®300 MIF developer, a relative molecular weight (RMW) of about 10 and a GPC Molecular Weight Distribution as shown In FIG. 1.

FIG. 1 is a graph showing the GPC molecular weignt distribution for the novolak resin of Example 1. The graph shows the Peak intensity plated as a function of the time in minutes.

Example 2

Synthesis of Navolak Resin using m-cresol and 3,5-xylenol (10:3.35 Ratio):

Into a 500 ml, four necked flask equipped with a thermometer, stirring shaft, condenser and a dropping funnel were added 115.35 grams (1.0667 moles) meta-cresol, 43.6 grams (0.35699 moles) 3,5-Xylenol, 76.13 grams diglyme solvent and 1.588 grams maleic anhydride (2.0% by weight of total phenols). The flask was heated slowly from room temperature using a heating mantle controlled by a thermo-watch. The contents of the flask were gently stirred. the reaction contents were heated to 95°C. When the temperature was stabilized at 95°C, 87.9 grams (37.28%) formaldehyde solution was added by dropping funnel over a period of one hour. The condensation was then carried out at 95°C for four hours. After condensation at 95°C, the distillation was carried out at atmospheric pressure to remove water. The temperature was increased to 200°C and excess cresol and solvent were removed under 4665 PA vaccum (35 mm Hg) at a temperature from 200 to 220°C. The vaccum was released at 220°C and the molten resin was poured into an aluminum pan. The resin obtained had a viscosity of 8.4 (7.0% solution in Cyclohexanone), a Glass transition Temperature (Tg = 92°C), a Dissolution Rate = 6.0 micrometers (microns)/minute using AZ® 300 MIF developer, an RMW of about 10 and a GPC Molecular Weight Distribution as shown in FIG. 2.

FIG. 2 is a graph showing the GPC molecular weight distribution for the novolak resin of Example 2. The graph shows the Peak Intensity plotted as a function of the time in minutes.

Example 3

Synthesis of Novolak Resin using m-cresol and 3,5-xylenol (6,23:3 Ratio):

Into a two liter four necked flask equipped with a thermometer, stirring shaft, condenser and a dropping funnel were added 162.12 grams (1.5 moles) meta-cresol. 88.08 grams (0.722 moles) 3,5-Xylenol, 170 grams DPGME solvent and 0.625 grams oxalic acid (0.25% by weight of total phenols). The flask was heated slowly from room temperature using a heating mantle controlled by a thermo-watch The contents of the flask were gently stirred. The reaction contents were heated to 95°C. When the temperature was stablized at 95°C, 121.6 grams (37.28.%) formaldehyde solution was added by dropping funnel over a period of 90 minutes. The condensation was then carried out at 95°C for six hours. After condensation at 95°C, to distillation was carried out at atmospheric pressure to remove water. The temperature was increased up to 200°C and excess cresol and solvent were removed under 4665 PA vaccum (35 mm Hg) at a temperature from 200 to 220°C. The vaccum was released at 220°C and the molten resin was poured into an aluminum pan. The resin obtained had a viscosity of 9.0 (7.0% solution in Cyclohexanone), a Glass transition Temperature (Tg = 90°C), a Dissolution Rate = 4.5-6.0 micrometers (microns)/minute using AZ300 MIF developer, a relative molecular weight (RMW) of about 8 and a GPC Molecular Weight Distribution as shown In FIG. 3.

FIG. 3 is a graph showing the GPC molecular weight distribution for the novolak resin of Example 3. The graph shows the Peak intensity plotted as a function of the time in minutes. Based on FIG. 1, 2, and 3: 1) a combination of the novolak resins of Examples 1 and 2 had an overlap of molecular weight distribution of greater than about ninety percent (90%) and 2) a combination of the novolak resins of Examples 1 and 3 had an overlap of molecular weight distribution of greater than about eighty five percent (85%).

Example 4

Photoreslst compositions were produced by adding to a 500 ml. flask: 4.5 grams of 70% L-sulfonyl chloride/30% F-sulfonyl chloride (70L/30F) trihydroxyphenylethane photosensitizer (18% by weignt ot the solids), 75 grams of PGMEA solvent anc the following amounts of the novolak resins of Examples 1 and 2. The mixtures were stirred et room temperature to form photoresist solutions (all percentages are by weight of solids):

| | Example 1 Novolak | Example 2 Novolak |
|---|---|---|
| A) | 20.500 grams (gm.) (82%) | ---- |
| B) | 15.375 grams (gm.) (61.5%) | 5.125 grams (gm.) (20.5%) |
| C) | 10.250 grams (gm.) (41%) | 10.250 grams (gm.) (41%) |
| D) | 5.125 grams (gm.) (20.5%) | 15.375 grams (gm.) (61.5%) |
| E) | ---- | 20.500 grams (gm.) (82%) |

The photoresist solutions were each coated on to a 10,2 centimeter (4') silicon wafer at the appropriate speed on a SVG coat-development track systems, then preexposure baked on a hot plate for 60 seconds at 95°C, to obtain a 0.975 µm film. The film thickness is determined on a Autonanospec (NANOMETRICS, model 215), an automated film thickness measurement system, measuring 10 point across the entire wafer. The wafers were then exposed to a NIKON i-line stepper (0.54 NA) with a NIKON resolution reticle. An 11 x 21 focus/exposure matrix is used to print a pattern on the resist film. The exposed wafer were post exposure baked (PEB) at 110°C for 60 seconds on a hot plate. The resists were subsequently spray-puddle developed for 45 seconds at 23.5°C, using TMAH AZ®300 MIF developer (available from Hoechst Celanese Corporation, Somerville, New Jersey). The developed resist pattern were examined by a Hitachi S-4000 field emission scanning electron microscope. The lithographic results of the samples are presented in the table below where:

$E_{nominal}$ = minimum dose (millijoules/cm.$^2$) required to replicate 1:1 the various feature sizes on the reticle

Resolution = smallest feature size [micrometers] (microns) opened with an acceptable pattem profile (pattern edge acuity > 80°)

Depth of focus = the extend of defocus [micrometers] (microns) of the optical exposure system where the resist is able to maintain an acceptable pattern profile and within ± 10% of the critical dimension (CD) at the $E_{nominal}$

Scum = resist residue left at the exposed areas after development.

| Lithographic Performance of the Resist | | | | |
|---|---|---|---|---|
| Sample | E(nominal) | Resolution µm(µ) | DOF 0.5 µm(µ) | Scum |
| A | 240 mJ/cm$^2$ | 0.35 | 1.4 µm | no |
| B | 200 | 0.40 | 1.4 µm | no |
| C | 210 | 0.35 | 1.4 µm | no |
| D | 200 | 0.35 | 1.4 µm | slightly |
| E | 160 | 0.35 | 1.4 µm | yes |

Sample A doesn't possess the process window needed to achieve the optimal thermal flow temperature, exposure latitude, depth of focus or $E_{nominal}$.

Example 5

Photoresist compositions were produced by adding to a 500 ml. flask: 50 grams of 70L/30F trihydroxyphenylethane photosensitizer (20% by weight of the solids), 75 grams of PGMEA solvent and the following amounts of the novolak resins of Examples 1 and 2. The mixtures were stirred at room temperature to form photoresist solutions (all percentages are by weight of solids).

| | Example 1 Novolak | Example 2 Novolak |
|---|---|---|
| A) | 20.00 grams (gm.) (80%) | 0.00 grams (gm.) (0%) |
| B) | 18.00 grams (gm.) (72%) | 2.00 grams (gm.) (8%) |
| C) | 16.00 grams (gm.) (64%) | 4.00 grams (gm.) (16%) |
| D) | 14.00 grams (gm.) (56%) | 6.00 grams (gm.) (24%) |
| E) | 12.00 grams (gm.) (48%) | 8.00 grams (gm.) (32%) |
| F) | 10.00 grams (gm.) (40%) | 10.00 grams (gm.) (40%) |

The photoresist samples of Example 5 were processed using the same conditions described in Example 4, except the resist thickness used was 1.185 µm and the post exposure bake temperatures used were 95°C to 110°C.

| | |
|---|---|
| $E_{clear}$ = | minimum dose (millijoules/cm.$^2$) required to dissolve all the resist at the exposed area upon developing, typically is fraction of the $E_{nominal}$ |
| Exposure Latitude = | percentage range of the exposure dose tolerated by the resist to print the pattern of a given feature size within ± 10% of Its Critical Dimension |
| DOF (0.5 µm) = | depth of focus [micrometers] (microns) for 0.5 µm feature size, determined by the method described in Example 4 |
| Thermal Flow Temperature = | lowest temperature (°C) at which the resist pattern start to flow or deform |

The results (see FIGS. 4 to 8 contour plots) clearly showed the benefit of using a novolak resin system comprising resin component with Bimodal Dissolution Rate, such as by blending various proportion of Example 2 novolak with the Example 1 novolak.

FIG. 4 is a contour plot of $E_{nominal}$ of the photoresist of Example 5 at Post Exposure (P.E.) Bake Temperatures from 95°C to 110°C. The plot shows $E_{nominal}$ decreased (i.e., photoresist photosensitivity increased) as the PEB temperatures decreased or the concentration of Example 2 novolak increased from 0% to 50% by weight. It also clearly showed using Example 1 novolak alone would not offer low $E_{nominal}$, even at a lower PEB temperature, which was found to give a lower thermal flow temperature.

FIG. 5 is a contour plot of Exposure (Expo.) Latitude of the Example 5 photoresists at PEB temperatures from 95°C to 110°C. This plot shows the exposure latitude increased as the Example 2 novolak content increased. The optimal exposure latitude is not achievable using 100% Example 1 novolak regardless of the PEB temperature used.

FIG. 8 is a contour plot of the Depth of Forcus (DOF) of a 0.5 micrometer (µ) photoresist pattem using the photoresists of Example 5 at PEB temperatures from 95°C to 110°C. Incorporation of some Example 2 novolak in the resin offered the best DOF.

FIG. 7 is a contour plot of $E_{clear}$ of the photoresist of Example 5 having a novolak resin content of 80% by weight of the solids in the photoresist composition at PEB temperatures from 95°C to 110°C and soft bake (SB, i.e. pre-exposure bake temperatures of 80°C to 120°C. The development time was 52 seconds using AZ 300 MIF developer. $E_{clear}$ increased as the SB and PEB temperatures increased.

FIG. 8 is a contour plot of the thermal flow temperature of the photoresist of Example 5 having a novolak resin content of 80% by weight of the solids in the photoresist composition at PEB temperatures from 95°C to 110°C and SB temperatures of 80°C to 120°C. The development time was 52 seconds using AZ®300 MIF developer. As clearly shown in this plot, higher SB and PEB temperatures increased the pattern thermal flow temperature.

Example 6

Photoresist compositions were produced by adding to a 500 ml. flask: 5.0 grams of 70L/30F trihydroxyphenylethane photosensitizer (18% by weight of the solids), 75 grams of PGMEA solvent and the following amounts of the novolak resins of Examples 1 and 2. The mixtures were stirred at room temperature to form photoresist solutions (all percentages are by weight of solids).

| | Example 1 Novolak | Example 2 Novolak |
|---|---|---|
| A) | 20.00 grams (gm.) (82%) | 0.00 grams (gm.) (0%) |
| B) | 18.00 grams (gm.) (73.8%) | 2.00 grams (gm.) (8.2%) |
| C) | 16.00 grams (gm.) (65.6%) | 4.00 grams (gm.) (16.4%) |
| D) | 14.00 grams (gm.) (57.4%) | 6.00 grams (gm.) (24.6%) |
| E) | 12.00 grams (gm.) (49.2%) | 8.00 grams (gm.) (32.8%) |
| F) | 10.00 grams (gm.) (41%) | 10.00 grams (gm.) (41%) |

The photoresist samples of Example 6 were processed using the same conditions described in Example 4, except the resist thickness used was 1.185 µm and the post exposure bake temperatures used were 95°C to 110°C.

FIG. 9 is a contour plot of the Expo. Latitude of the photoresists of Example 6 at PEB temperatures from 95°C to 110°C. The plot showed the same trend as those seen in FIG. 5 for Example 5. Incorporation of some of the Example 2 novolak improved the expo. latitude. Resists in this example contained lower sensitizer concentration, as compared to those resists in Example 5.

FIG. 10 is a contour plot of the DOF of a 0.5µm(µ) photoresist pattem using the photoresists of Example 6. Similar to the results found in Example 5, DOF improved with the incorporation of some of the Example 2 novolak.

Example 7

Photoresist compositions were produced by adding to a 500 ml. flask: various amount of 70L/30F trihydroxyphenylethaane photosensitiser (20%, 19%, 18% by weight of solid), 75 grams of PGMEA solvent and the following amounts of the novolak resins of Example 1, 2 and 3. The mixtures were stirred at room temperature to form photoresist solutions (all percentages are by weight of solids)

| | Exp. 1 Novolak | Exp. 2 Novolak | Exp. 3 Novolak | PAC |
|---|---|---|---|---|
| A) | 20 grams(gm) (80%) | 0 grams(gm) (0%) | 0 grams(gm) (0%) | 5 grams(gm) (20%) |
| B) | 0 grams(gm) (0%) | 20 grams(gm) (80%) | 0grams(gm) (0%) | 5 grams(gm) (20%) |
| C) | 10grams(gm) (40%) | 0 grams(gm) (0%) | 10 grams(gm) (40%) | 5 grams (gm) (20%) |
| D) | 10.125 grams (gm) (40.5%) | 0 grams (gm)(0%) | 10.125 grams (gm)(40.5%) | 4.75 grams(gm) (19%) |
| E) | 10.25grams (gm)(41%) | 0 grams (gm)(0%) | 10.25grams (gm)(41%) | 4.5 grams(gm) (18%) |

| Lithographic Performance of the Resist | | | | |
|---|---|---|---|---|
| Sample | E(nominal) | Resolutionµm(µ) | DOF0.5µm (µ) | Scum |
| A | 240 mJ/cm$^2$ | 0.35 | 1.4 µm | no |
| B | 160 | 0.35 | 1.4 µm | yes |
| C | 190 | 0.35 | 1.4 µm | no |
| D | 160 | 0.35 | 1.4 µm | no |
| E | 170 | 0.40 | 1.4 µm | no |

Solution Viscosity - Relative Molecular Weight (RMW):

The viscosity solution was prepared by dissolving 7 grams of novolak resin in a 100 ml. volumetric flask, using cyclohexanone solvent. The solution was filtered using a 5 micrometer (micron) pressure syringe filter. The viscosity was measured using a Cannon-fenske #200 viscometer at 25°C. The relative molecular weight (RMW) was determined using the following equation:

$$M_{rel} = \left[ 1/C \log \left( \frac{n}{no} \right) \right]^2$$

where

c = concentration of resin in g/ml.
n = viscosity of resin in cyclohexanone
no = viscosity of cyclohexanone

Dissolution Rate Measurement:

Formulations:

Dissolve 26% resin solids in PGMEA. Filter through a 0.2 µm disposable Acrodisc filter.

Reference Standards:

S-Resin Stock #D9922A produced by Hoechst Celanese Corporation (supplied in PGMEA solvent).

Dissolution Rate Measurement Procedure:

1. Each sample was coated on a 14 inch silicon wafer, at the appropriate speed, on an SVG coat-development track system, then baked on a hot plate for 60 seconds at 90°C, to obtain a 1.20 µm film.
2. The film thickness was determined on an Autonanospec (NANOMETRICS, model 215), an automated film thickness measurement system, measuring 10 points across the entire wafer.
3. The Dissolution Rate was determined by measuring the film thickness change with time using a laser end-point detection systemconsists of a He-Ne laser (634 nm, 3 mW, ORIEL CORP., Model 79202) and a photodiode. The development was performed at 21°C using AZ®300 MIF TMAH developer and the dissolution rate was calculated by the equation

$$\Delta t = \lambda/2n$$

where $\lambda$ is the wavelength of the laser, n is the Index of reflection of the film material at that wavelength and $\Delta t$ is the change in thickness that occurs in the time span between maxima (or minima) interference of the film during the dissolution process.

Molecular Weight Data (Mw and Mn):

The molecular weight of the polymers, whether weight average molecular weight Mw, or number average molecular weight Mn, were measured by gel permeation chromatography (GPC) performed on dilute solutions of the polymer in tetrahydrofuran (THF). The actual apparatus employed consisted of a Waters (Millipore Corp.) programmable automatic sampler, vacuum pump, chromatography columns with heater, and a differential refractometer connected to a Shimadzu CR 30A data reduction system with accompanying software (version 1.1, Shimadzu part No. T/N 22301309-91). The refractometer used was a Waters model 410 and four chromatography columns. $500 \times 10^{-4}$ micrometers (Angstrom), $1000 \times 10^{-4}$ micrometers (Angstrom), $10{,}000 \times 10^{-4}$ micrometers (Angstrom) and $100{,}000 \times 10^{-4}$ micrometers (Angstrom) (available from Waters) were connected in series. The system was calibrated using multiple available polystyrene standards ranging in molecular weight as follows:

| GPC CALIBRATION | |
|---|---|
| Calibration Standard (Polystyrene) | Mol. Wt. |
| 1 | 470,000 |
| 2 | 170,000 |
| 3 | 68,000 |
| 4 | 34,500 |
| 5 | 9,200 |
| 6 | 3,200 |
| 7 | 1,250 |

The standards are essentially monodisperse, consisting substantially of a single molecular weight. With the system thus calibrated the weight average molecular weight (Mw), the number average molecular weight (Mn), and polydispersity (Mw/Mn), were obtained for polymers produced in accordance with the Examples.

Glass Transition Temperature (Tg):

Glass transistor temperatures (Tg) were determined by differential scanning calorimetry using a Parkin Elmer DSC-4 calorimeter operating at 20°C/minute, nitrogen atmosphere at 60 cubic centimeters (cc)/minute. Glass transition temperature by this method is generally defined as the point of intersection of tangent lines about the point of first inflection of the heating curve of the polymer.

**Claims**

**1.** A liquid, positive photoresist comprising an admixture of:

a) a photosensitive component in an amount sufficient to uniformly photosensitize the photoresist composition;
b) a water insoluble, aqueous alkali soluble film forming novolak resin in an amount sufficient to form a substantially uniform photoresist composition, the novolak resin comprising a mixture of at least two novolak resins for which the GPC molecular weight distribution of the component resins, determined versus a polystyrene standard normalized to the same area, show an overlap of at least fifty percent (50%) and for which the dissolution rates in AZ300 MIF TMAH developer of the component resins differ by a factor of from 2.0 to 6.0, said novolak resins being the reaction products of formaldehyde with a mixture of meta-cresol and 3,5-xylenol, and
c) a suitable solvent.

**2.** The photoresist composition of claim 1 wherein the novolak resins show an overlap in molecular weight distribution of 60 to 100 percent.

**3.** The photoresist composition of claim 2 wherein the novolak resins show an overlap in molecular weight distribution of 70 to 95 percent.

**4.** The photoresist composition of any of claims 1-3 wherein the amount of novolak resin in the photoresist composition ranges from about 70 percent to about 90 percent, based on the weight of solids.

**5.** The photoresist composition of any of claims 1-4 wherein the photosensitive component comprises an ester of a multihydroxy phenolic compound.

**6.** The photoresist composition of claim 5 wherein the photosensitive component comprises a sulfonic acid derivative of a tris-hydroxyphenylethane.

**7.** The photoresist composition of any of claims 1-6 wherein the solvent is selected from the group consisting of: propylene glycol mono-alkyl ether, propylene glycol methyl ether acetate, ethyl-3-ethoxypropionate, ethyl lactate, mixtures of ethyl-3-ethoxypropionate and ethyl lactate, mixtures of ethyl-3-ethoxypropionate and ethyl lactate, butyl acetate, xylene, diglyme and ethylene glycol monoethyl ether acetate.

**8.** The photoresist composition of claim 7 wherein the solvent comprises either propylene glycol methyl ether acetate or ethyl-3-ethoxypropionate.

**9.** A process for formulating a photoresist composition solution by providing an admixture of:

1) a photosensitive component in an amount sufficient to uniformly photosensitize the photoresist composition;
2) a water insoluble, aqueous alkali soluble film forming novolak resin in an amount sufficient to form a substantially uniform photoresist composition, the novolak resin comprising a mixture of at least two novolak resins, for which the GPC molecular weight distribution of the component resins, determined versus a polystyrene standard normalized to the same area, show an overlap of at least fifty percent (50%) and for which the dissolution rates in AZ300 MIF TMAH developer of the component resins differ by a factor of from 2.0 to 6.0, said novolak resins being the reaction products of formaldehyde with a mixture of meta-cresol and 3,5-xylenol, and
3) a suitable solvent.

**10.** The process of claim 9 incorporating the features of any of claims 2-8.

**11.** The process of claim 9 or 10 wherein the novolak resins have dissolution rates which differ by a factor of 2.0 to 6.0.

**12.** A method for producing a semiconductor device by producing a photo-image on a substrate by coating a suitable substrate with a photoresist composition solution by:

a) formulating a photoresist composition in accordance with any of claims 1-8 or produced by the process of any of claims 9-11;
b) coating a suitable substrate with the photoresist composition;
c) heat treating the coated substrate until substantially all of the solvent is removed; image-wise exposing the photosensitive composition and removing the image-wise exposed areas of such composition with a suitable developer.

**13.** The method of claim 12 wherein the developer is an aqueous alkaline developer.

**14.** The method of claim 12 or 13 further comprising heating said coated substrate from a temperature of from 90°C to 150°C for from 30 seconds to 180 seconds on a hot plate or from 15 minutes to 40 minutes in an oven after the exposure step but before the removing step.

**15.** The method of claim 12 or 13 further comprising heating said coated substrate at a temperature of from 90°C to 150°C for 30 seconds to 180 seconds on a hot plate or for from 15 minutes to 40 minutes in an oven after the removing step.

**16.** The method of any of claims 12 to 15 wherein said substrate comprises one or more components selected from the group consisting of silicon, aluminum, polymeric resins, silicon dioxide, doped silicon dioxide, silicon nitride, tantalum, copper and polysilicon.

**17.** The method of any of claims 12 to 16 wherein the novolak resins have dissolution rates which differ by a factor of 2.0 to 6.0.

**18.** A semiconductor device produced by providing photo-image on a substrate by:

a) coating a suitable substrate with a photoresist composition in accordance with any of claims 1 to 8 or produced by the process of any of claims 9 to 11;
b) heat treating the coated substrate until substantially all of the solvent is removed;
c) image-wise exposing the photosensitive composition and
d) removing the image-wise exposed areas of such composition with a suitable developer.

**19.** The semiconductor device of claim 18 wherein the substrate is selected from the group consisting of silicon, aluminum, polymeric resins, silicon dioxide, doped silicon dioxide, gallium arsenide, Group III/V compounds, silicon nitride, tantalum, copper, polysilicon, ceramics and aluminum/copper mixtures.

**20.** The semi-conductor device of claim 18 or 19 wherein the substrate has an adhesion promoted surface.

**Patentansprüche**

1. Flüssiger Positiv-Photoresist, umfassend eine Mischung aus:

   a) einer lichtempfindlichen Komponente in einer Menge, die ausreichend ist, um die Photoresist-Zusammensetzung gleichmäßig lichtempfindlich zu machen;

   b) einem wasserunlöslichen, in wässrigem Alkali löslichen, einen Novolak-Harz bildenden Film in einer Menge, die ausreichend ist, um eine im wesentlichen gleichmäßige Photoresist-Zusammensetzung zu bilden, wobei das Novolak-Harz eine Mischung aus wenigstens zwei Novolak-Harzen umfaßt, für die die GPC-Molmassen-Verteilung der Harze der Komponenten, bestimmt gegen einen auf dieselbe Fläche normalisierten Polystyrol-Standard, eine Überlappung von wenigstens 50 Prozent (50 %) zeigt und für die die Auflösungsgeschwindigkeiten der Komponenten der Harze in AZ300-MIF-TMAH-Entwickler um einen Faktor von 2,0 bis 6,0 differieren, wobei die Novolak-Harze die Reaktionsprodukte von Formaldehyd mit einer Mischung aus Meta-Kresol und 3,5-Xylenol sind, und

   c) einem geeigneten Lösungsmittel.

2. Photoresist-Zusammensetzung nach Anspruch 1, wobei die Novolak-Harze ein Überlappen der Molmassen-Verteilung von 60 bis 100 Prozent zeigen.

3. Photoresist-Zusammensetzung nach Anspruch 1, wobei die Novolak-Harze ein Überlappen der Molmassen-Verteilung von 70 bis 95 Prozent zeigen.

4. Photoresist-Zusammensetzung nach einem der Ansprüche 1 - 3, wobei die Menge des Novolak-Harzes in der Photoresist-Zusammensetzung von etwa 70 Prozent bis etwa 90 Prozent, bezogen auf das Gewicht der Feststoffe, reicht.

5. Photoresist-Zusammensetzung nach einem der Ansprüche 1 - 4, wobei die lichtempfindliche Komponente einen Ester einer phenolischen Multihydroxy-Verbindung umfaßt.

6. Photoresist-Zusammensetzung nach Anspruch 5, wobei die lichtempfindliche Komponente ein Sulfonsäure-Derivat eines Trishydroxyphenylethans umfaßt.

7. Photoresist-Zusammensetzung nach einem der Ansprüche 1 - 6, wobei das Lösungsmittel aus der aus: Propylenglycolmonoalkylether, Propylenglycolmethyletheracetat, Ethyl-3-ethoxypropionat, Ethyllactat, Mischungen von Ethyl-3-ethoxypropionat und Ethyllactat, Mischungen von Ethyl-3-ethoxypropionat und Ethyllactat, Butylacetat, Xylol, Diglyme und Ethylenglycolmonoethyletheracetat ausgewählt ist.

8. Photoresist-Zusammensetzung nach Anspruch 7, wobei das Lösungsmittel entweder Propylenglycolmethyletheracetat oder Ethyl-3-ethoxypropionat umfaßt.

9. Verfahren zum Formulieren einer Photoresist-Zusammensetzung durch das Bereitstellen einer Mischung aus:

   a) einer lichtempfindlichen Komponente in einer Menge, die ausreichend ist, um die Photoresist-Zusammensetzung gleichmäßig lichtempfindlich zu machen;

   b) einem wasserunlöslichen, in wässrigem Alkali löslichen, einen Novolak-Harz bildenden Film in einer Menge, die ausreichend ist, um eine im wesentlichen gleichmäßige Photoresist-Zusammensetzung zu bilden, wobei das Novolak-Harz eine Mischung aus wenigstens zwei Novolak-Harzen umfaßt, für die die GPC-Molmassen-Verteilung der Harze der Komponenten, bestimmt gegen einen auf dieselbe Fläche normalisierten Polystyrol-Standard, eine Überlappung von wenigstens 50 Prozent (50 %) zeigt und für die die Auflösungsgeschwindigkeiten der Komponenten der Harze um einen Faktor von 2,0 bis 6,0 differieren, wobei die Novolak-Harze die Reaktionsprodukte von Formaldehyd mit einer Mischung aus Meta-Kresol und 3,5-Xylenol sind, und

   c) einem geeigneten Lösungsmittel.

10. Verfahren nach Anspruch 9, das die Merkmale eines der Ansprüche 2 - 8 aufweist.

**11.** Verfahren nach Anspruch 9 oder 10, wobei die Novolak-Harze Auflösungsgeschwindigkeiten aufweisen, die um einen Faktor von 2,0 bis 6,0 differieren.

**12.** Verfahren zur Herstellung eines Halbleiter-Bauelements durch das Erzeugen eines Photobilds auf einem Substrat durch das Beschichten eines geeigneten Substrats mit der Lösung einer Photoresist-Zusammensetzung durch das:

a) Formulieren einer Photoresist-Zusammensetzung nach einem der Ansprüche 1 - 8 oder hergestellt durch das Verfahren nach einem der Ansprüche 9 - 11;

b) Beschichten eines geeigneten Substrats mit der Photoresist-Zusammensetzung;

c) Wärmebehandeln des beschichteten Substrats, bis im wesentlichen das gesamte Lösungsmittel entfernt ist; das bildweise Belichten der lichtempfindlichen Zusammensetzung und das Entfernen der bildweise belichteten Bereiche einer solchen Zusammensetzung mit einem geeigneten Entwickler.

**13.** Verfahren nach Anspruch 12, wobei der Entwickler ein wässriger, alkalischer Entwickler ist.

**14.** Verfahren nach Anspruch 12 oder 13, weiterhin umfassend das Erwärmen des beschichteten Substrats auf eine Temperatur von 90 °C bis 150 °C für 30 s bis 180 s auf einer Heizplatte oder für 15 min bis 40 min in einem Ofen nach dem Belichtungsschritt, aber vor dem Schritt des Entfernens.

**15.** Verfahren nach Anspruch 12 oder 13, weiterhin umfassend das Erwärmen des beschichteten Substrats auf eine Temperatur von 90 °C bis 150 °C für 30 s bis 180 s auf einer Heizplatte oder für 15 min bis 40 min in einem Ofen nach dem Schritt des Entfernens.

**16.** Verfahren nach einem der Ansprüche 12 bis 15, wobei das Substrat eine oder mehrere Komponenten, ausgewählt aus der aus Silicium, Aluminium, polymeren Harzen, Siliciumdioxid, dotiertem Siliciumdioxid, Siliciumnitrid, Tantal, Kupfer und Polysilicium bestehenden Gruppe, umfaßt.

**17.** Verfahren nach einem der Ansprüche 12 bis 16, wobei die Novolak-Harze Auflösungsgeschwindigkeiten aufweisen, die um einen Faktor von 2,0 bis 6,0 differieren.

**18.** Halbleiter-Bauelement, hergestellt durch das Bereitstellen eines Photobildes auf einem Substrat durch das:

a) Beschichten eines geeigneten Substrats mit einer Photoresist-Zusammensetzung nach einem der Ansprüche 1 bis 8 oder hergestellt durch das Verfahren nach einem der Ansprüche 9 bis 11;

b) Wärmebehandeln des beschichteten Substrats, bis im wesentlichen das gesamte Lösungsmittel entfernt ist;

c) bildweise Belichten der lichtempfindlichen Zusammensetzung und

d) Entfernen der bildweise belichteten Bereiche einer solchen Zusammensetzung mit einem geeigneten Entwickler.

**19.** Halbleiter-Bauelement nach Anspruch 18, wobei das Substrat aus der aus Silicium, Aluminium, polymeren Harzen, Siliciumdioxid, dotiertem Siliciumdioxid, Galliumarsenid, Verbindungen der Gruppe III/V, Siliciuimnitrid, Tantal, Kupfer, Polysilicium, Keramiken und Mischungen aus Aluminium/Kupfer bestehenden Gruppe ausgewählt ist.

**20.** Halbleiter-Bauelement nach Anspruch 18 oder 19, wobei das Substrat eine Haftmittel-Oberfläche aufweist.

## Revendications

**1.** Composition de réserve photochimique positive liquide, comprenant un mélange :

a) d'un constituant photosensible en une quantité suffisante pour photosensibiliser uniformément la composition de réserve photochimique ;

b) une résine novolaque formant un film insoluble dans l'eau, soluble dans une solution alcaline aqueuse, en une quantité suffisante pour former une composition de réserve photochimique pratiquement uniforme, résine novolaque qui comprend un mélange d'au moins deux résines novolaques pour laquelle la distribution des poids moléculaires par CPG des résines constitutives, déterminée par rapport à un échantillon de polystyrène de référence normalisé à la même surface, présente un chevauchement d'au moins cinquante pour cent (50 %), et pour laquelle les vitesses de dissolution dans le développateur AZ300 MIF TMAH des résines constitutives diffèrent suivant un facteur de 2,0 à 6,0, lesdites résines novolaques étant les produits de réaction du formaldéhyde avec un mélange de métacrésol et de 3,5-xylénol, et
c) d'un solvant convenable.

**2.** Composition de réserve photochimique suivant la revendication 1, dans laquelle les résines novolaques présentent un chevauchement dans la distribution des poids moléculaires de 60 à 100 pour cent.

**3.** Composition de réserve photochimique suivant la revendication 2, dans laquelle les résines novolaques présentent un chevauchement dans la distribution des poids moléculaires de 70 à 95 pour cent.

**4.** Composition de réserve photochimique suivant l'une quelconque des revendications 1 à 3, dans laquelle la quantité de résine novolaque dans la composition de réserve photochimique va d'environ 70 pour cent à environ 90 pour cent, sur la base du poids des matières solides.

**5.** Composition de réserve photochimique suivant l'une quelconque des revendications 1 à 4, dans laquelle le constituant photosensible comprend un ester d'un composé phénolique multihydroxylique.

**6.** Composition de réserve photochimique suivant la revendication 5, dans laquelle le constituant photosensible comprend un dérivé d'acide sulfonique d'un trishydroxyphényléthane.

**7.** Composition de réserve photochimique suivant l'une quelconque des revendications 1 à 6, dans laquelle le solvant est choisi dans le groupe consistant en : éther monoalkylique de propylène-glycol, acétate d'éther méthylique de propylène-glycol, 3-éthoxypropionate d'éthyle, lactate d'éthyle, mélanges de 3-éthoxypropionate d'éthyle et de lactate d'éthyle, mélanges de 3-éthoxypropionate d'éthyle et de lactate d'éthyle, acétate de butyle, xylène, diglyme et acétate d'éther mono-éthylique d'éthylène-glycol.

**8.** Composition de réserve photochimique suivant la revendication 7, dans laquelle le solvant comprend l'acétate d'éther méthylique de propylène-glycol ou le 3-éthoxypropionate d'éthyle.

**9.** Procédé de formulation d'une solution de composition de réserve photochimique en formant un mélange :

1) d'un constituant photosensible en une quantité suffisante pour photosensibiliser uniformément la composition de réserve photochimique ;
2) d'une résine novolaque formant un film insoluble dans l'eau, soluble dans une solution alcaline aqueuse, en une quantité suffisante pour former une composition de réserve photochimique pratiquement uniforme, résine novolaque qui comprend un mélange d'au moins deux résines novolaques, pour laquelle la distribution des poids moléculaires par CPG des résines constitutives, déterminée par rapport à un échantillon de polystyrène de référence normalisé à la même surface, présente un chevauchement d'au moins cinquante pour cent (50 %), et pour laquelle les vitesses de dissolution dans le développateur AZ300 MIF TMAH des résines constitutives diffèrent d'un facteur de 2,0 à 6,0, lesdites résines novolaques étant les produits de réaction du formaldéhyde avec un mélange de métacrésol et de 3,5-xylénol, et
3) un solvant convenable.

**10.** Procédé suivant la revendication 9, comprenant les caractéristiques suivant l'une quelconque des revendications 2 à 8.

**11.** Procédé suivant la revendication 9 ou 10, dans lequel les résines novolaques ont des vitesses de dissolution qui diffèrent d'un facteur de 2,0 à 6,0.

**12.** Procédé pour la production d'un dispositif à semiconducteurs par production d'une photo-image sur un substrat en revêtant un substrat convenable avec une solution de composition de réserve photochimique par :

a) formulation d'une composition de réserve photochimique suivant l'une quelconque des revendications 1 à 8 ou produite par le procédé suivant l'une quelconque des revendications 9 à 11 ;
b) revêtement d'un substrat convenable avec la composition de réserve photochimique ;
c) traitement thermique du substrat revêtu jusqu'à ce que pratiquement la totalité du solvant soit éliminée ; exposition à des fins de formation d'image de la composition photosensible et élimination des zones exposées à des fins de formation d'image de cette composition avec un développateur convenable.

**13.** Procédé suivant la revendication 12, dans lequel le développateur est un développateur alcalin aqueux.

**14.** Procédé suivant la revendication 12 ou 13, comprenant en outre le chauffage du substrat revêtu d'une température de 90°C à 150°C pendant un temps de 30 secondes à 180 secondes sur une plaque chauffante ou pendant un temps de 15 minutes à 40 minutes dans un four après l'étape d'exposition mais avant l'étape d'élimination.

**15.** Procédé suivant la revendication 12 ou 13, comprenant en outre le chauffage du substrat revêtu à une température de 90°C à 150°C pendant un temps de 30 secondes à 180 secondes sur une plaque chauffante ou pendant un temps de 15 minutes à 40 minutes dans un four après l'étape d'élimination.

**16.** Procédé suivant l'une quelconque des revendications 12 à 15, dans lequel le substrat comprend un ou plusieurs substituants choisis dans le groupe consistant en silicium, aluminium, résines polymériques, dioxyde de silicium, dioxyde de silicium dopé, nitrure de silicium, tantale, cuivre et silicium polycristallin.

**17.** Procédé suivant l'une quelconque des revendications 12 à 16, dans lequel les résines novolaques ont des vitesses de dissolution qui diffèrent d'un facteur de 2,0 à 6,0.

**18.** Dispositif à semiconducteurs produit en formant une photo-image sur un substrat par :

a) revêtement d'un substrat convenable avec une composition de réserve photochimique suivant l'une quelconque des revendications 1 à 8 ou produite par le procédé suivant l'une quelconque des revendications 9 à 11 ;
b) traitement thermique du substrat revêtu jusqu'à ce que pratiquement la totalité du solvant soit éliminée ;
c) exposition à des fins de formation d'image de la composition photosensible et
d) élimination des zones exposées à des fins de formation d'image de cette composition avec un développateur convenable.

**19.** Dispositif à semiconducteurs suivant la revendication 18, dans lequel le substrat est choisi dans le groupe consistant en silicium, aluminium, résines polymériques, dioxyde de silicium, dioxyde de silicium dopé, arséniure de gallium, composés d'éléments des Groupes III/V, nitrure de silicium, tantale, cuivre, silicium polycristallin, matières céramiques et mélanges aluminium/cuivre.

**20.** Dispositif à semiconducteurs suivant la revendication 18 ou 19, dans lequel le substrat a une surface à adhérence activée.

FIG. 1

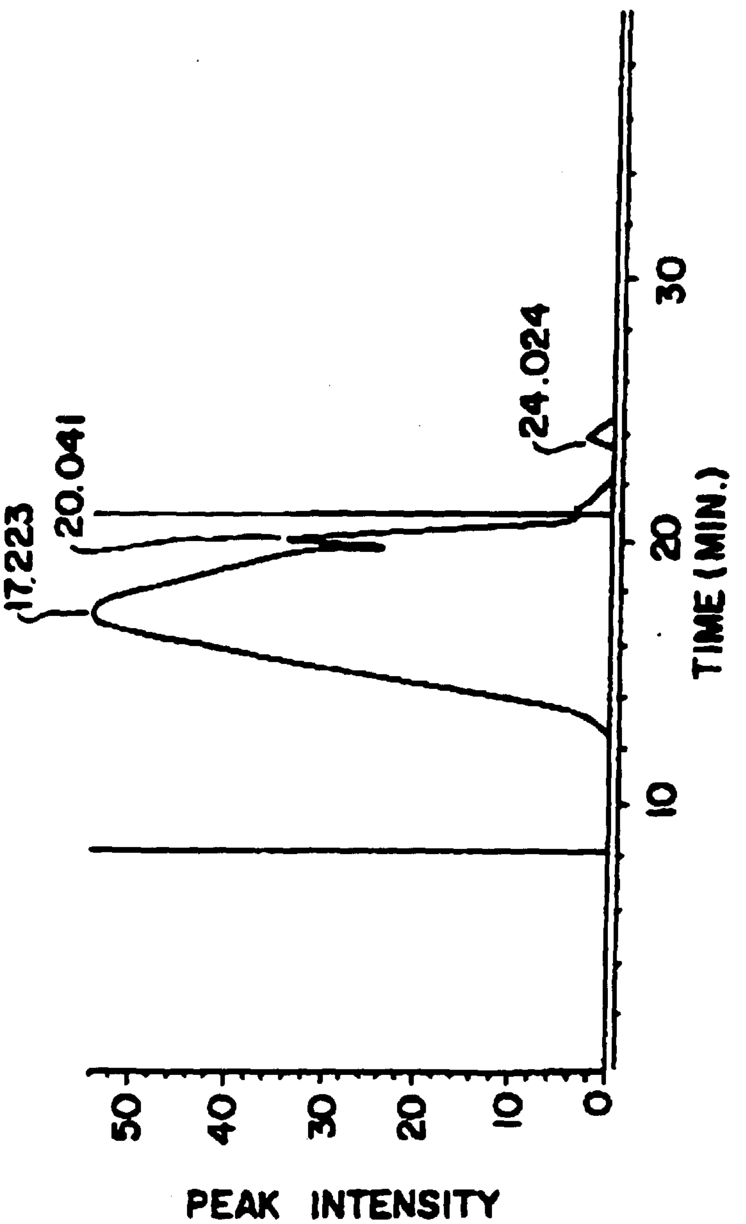
17.223
20.041
24.024
10
20
30
TIME (MIN.)
0
10
20
30
40
50
PEAK INTENSITY

FIG.2

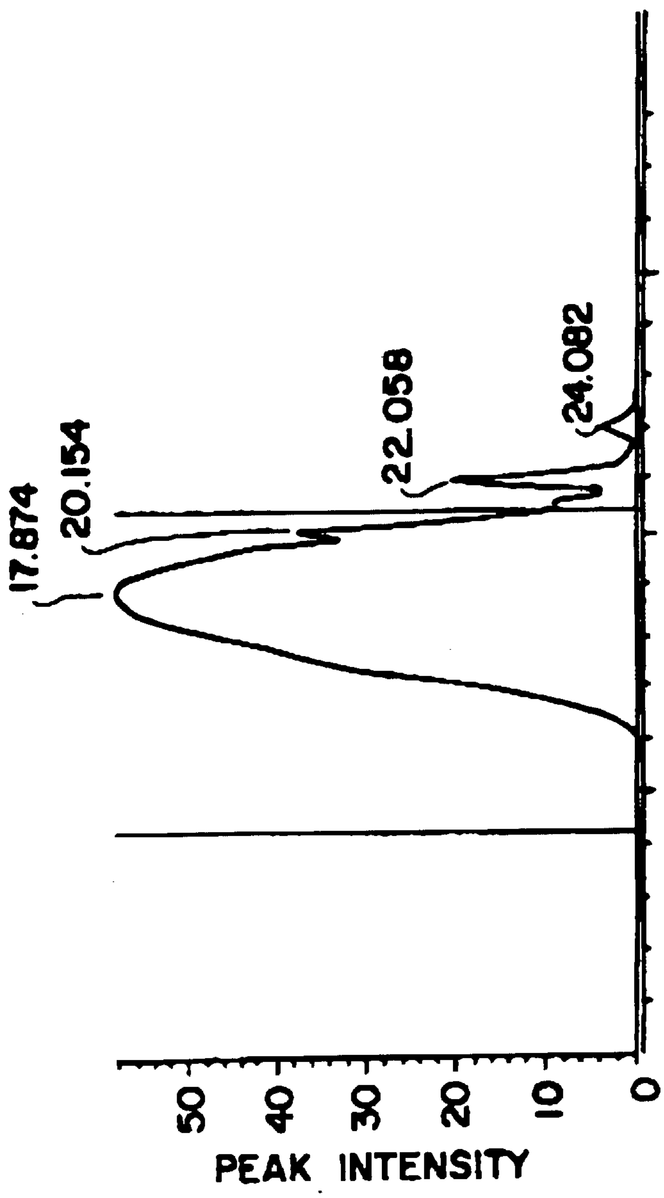
17.874
20.154
22.058
24.082
PEAK INTENSITY
0
10
20
30
40
50
TIME (MIN.)
10
20
30

FIG.3

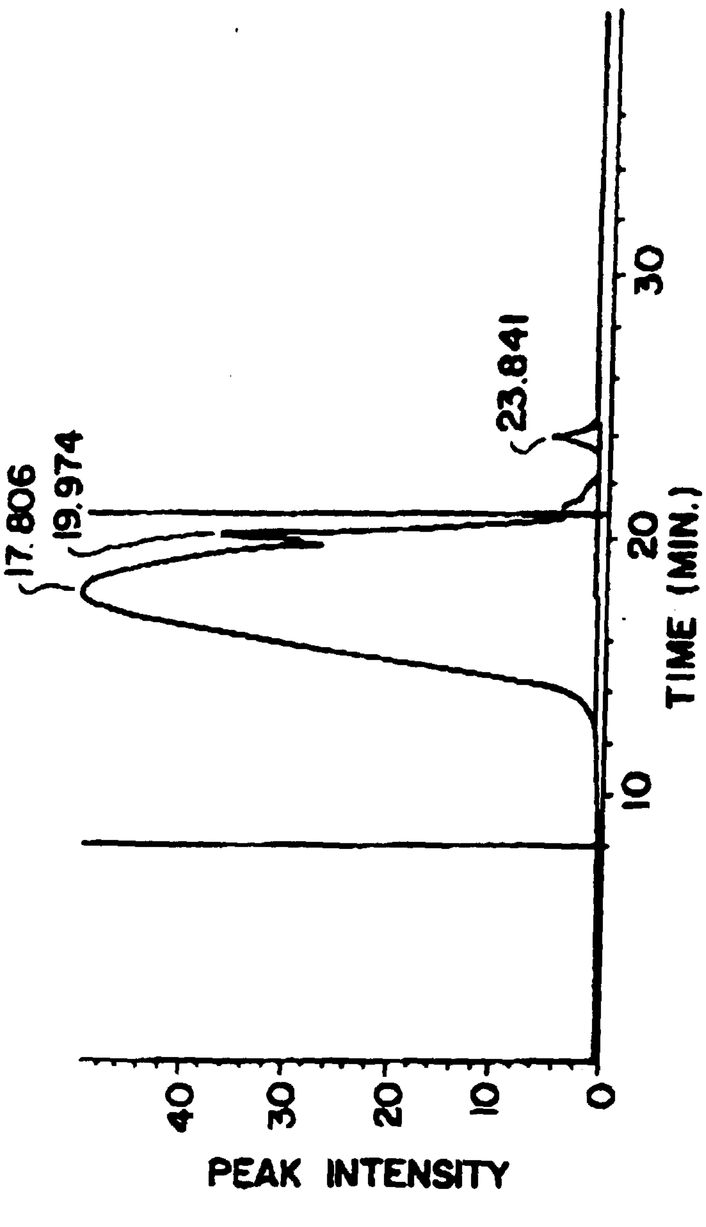
17.806
19.974
23.841
10
20
30
TIME (MIN.)
40
30
20
10
0
PEAK INTENSITY

FIG.4

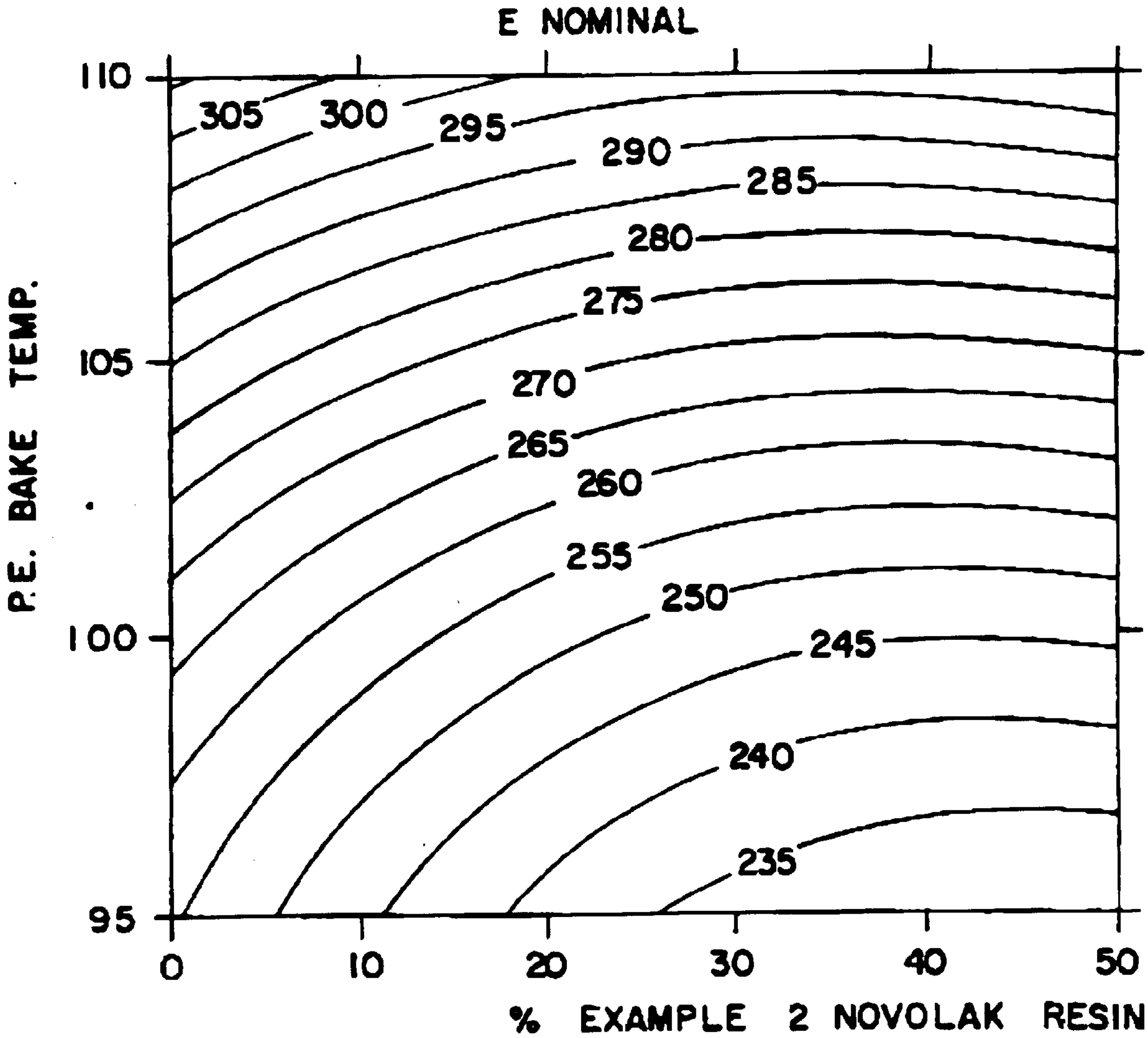
E NOMINAL
110
105
100
95
P.E. BAKE TEMP.
305
300
295
290
285
280
275
270
265
260
255
250
245
240
235
0
10
20
30
40
50
% EXAMPLE 2 NOVOLAK RESIN

FIG.5

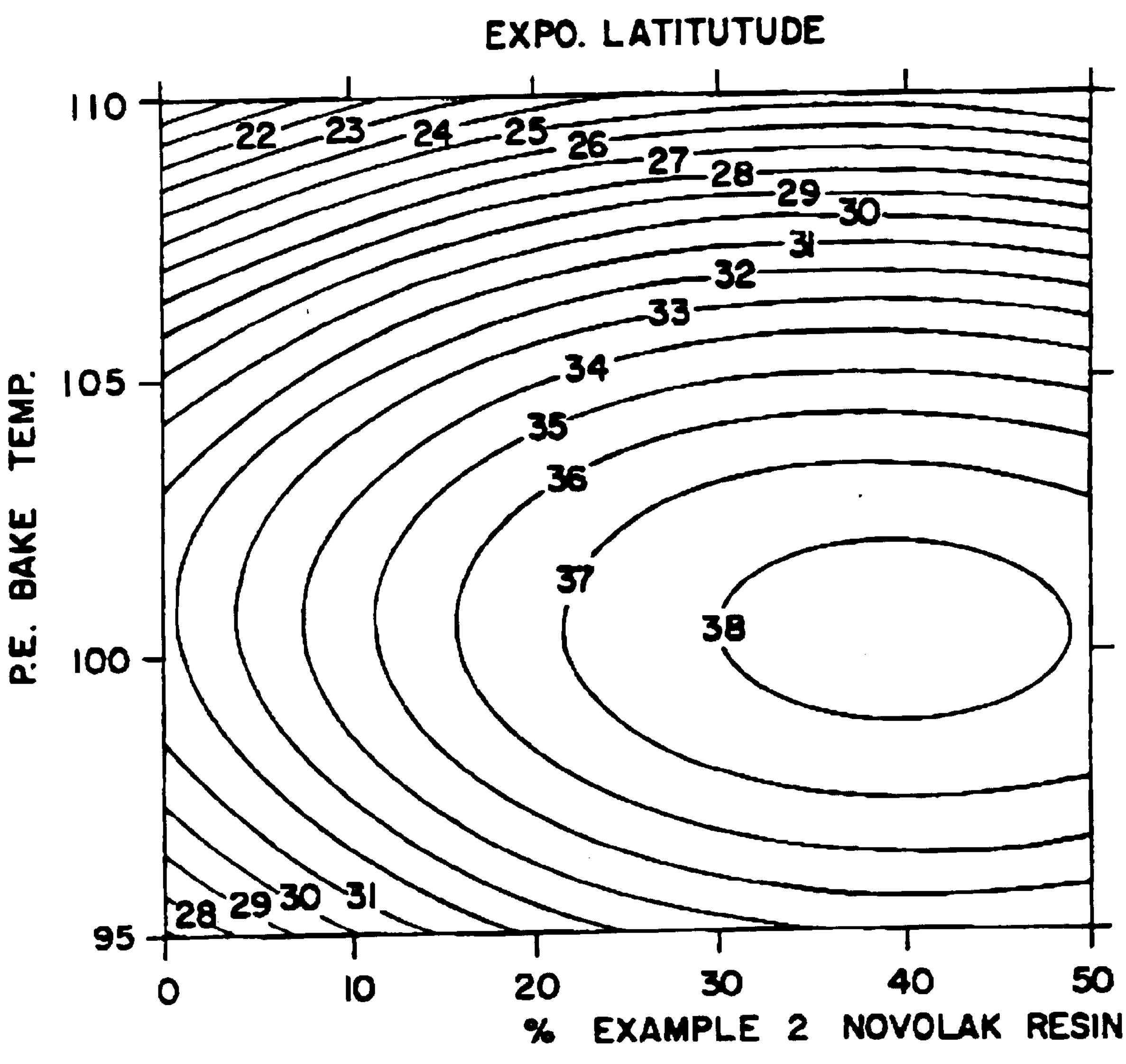
EXPO. LATITUTUDE
110
105
100
95
P.E. BAKE TEMP.
0
10
20
30
40
50
% EXAMPLE 2 NOVOLAK RESIN
22
23
24
25
26
27
28
29
30
31
32
33
34
35
36
37
38
28
29
30
31

FIG.6

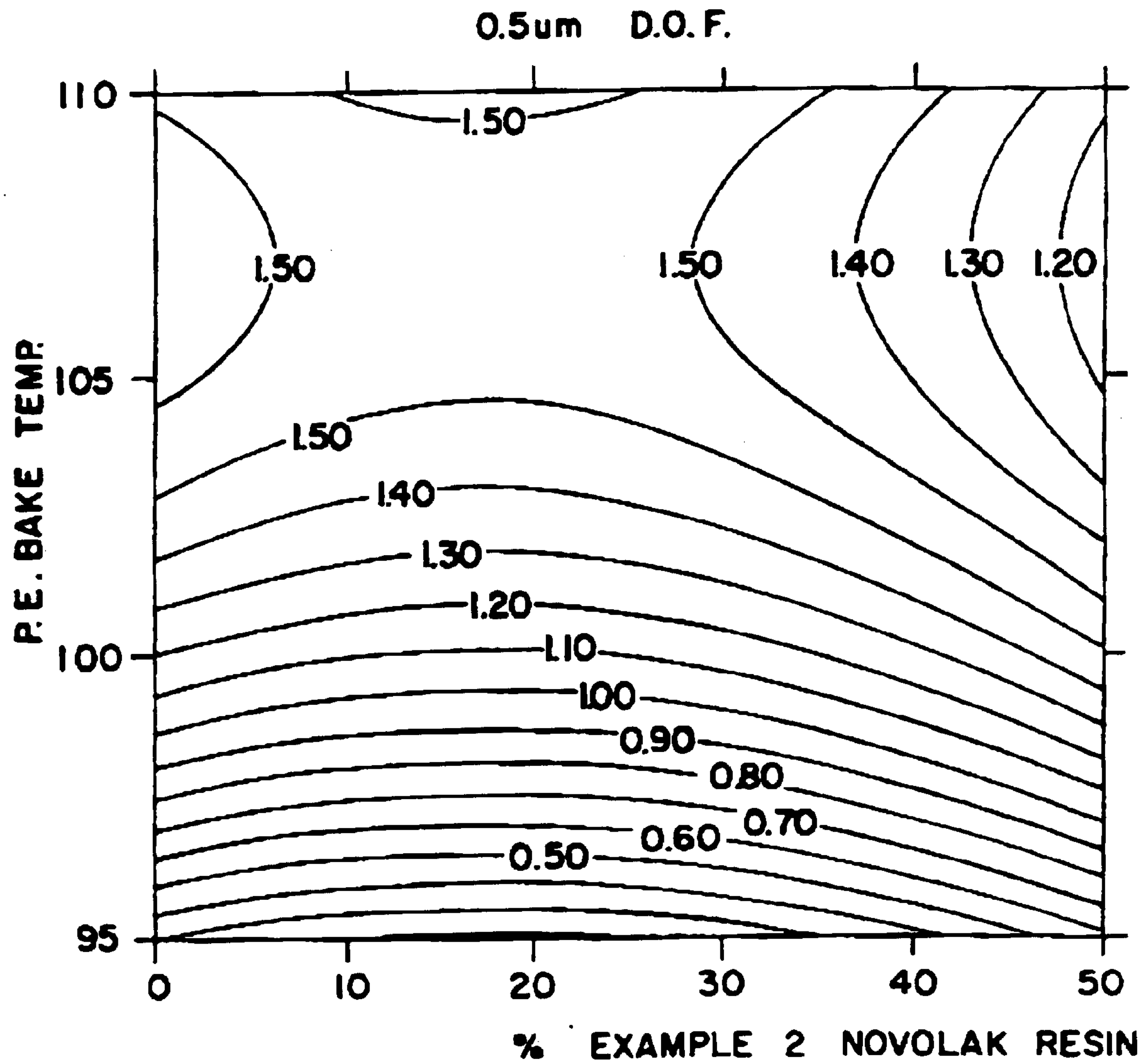
0.5um D.O.F.
110
105
100
95
P.E. BAKE TEMP.
1.50
1.50
1.50
1.40
1.30
1.20
1.50
1.40
1.30
1.20
1.10
1.00
0.90
0.80
0.70
0.60
0.50
0
10
20
30
40
50
% EXAMPLE 2 NOVOLAK RESIN

FIG.7

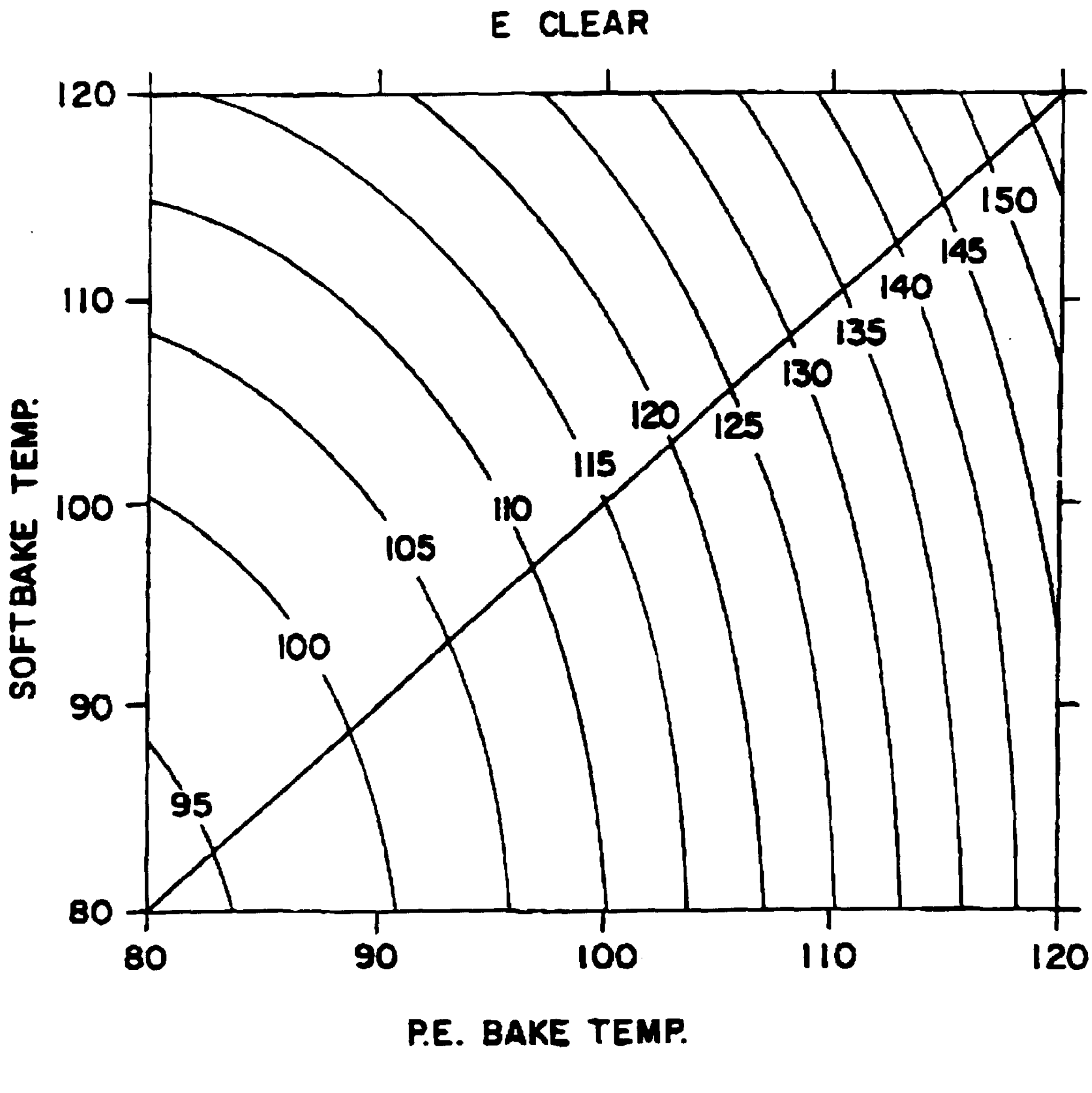
E CLEAR
SOFTBAKE TEMP.
P.E. BAKE TEMP.
80
90
100
110
120
80
90
100
110
120
95
100
105
110
115
120
125
130
135
140
145
150

FIG.8

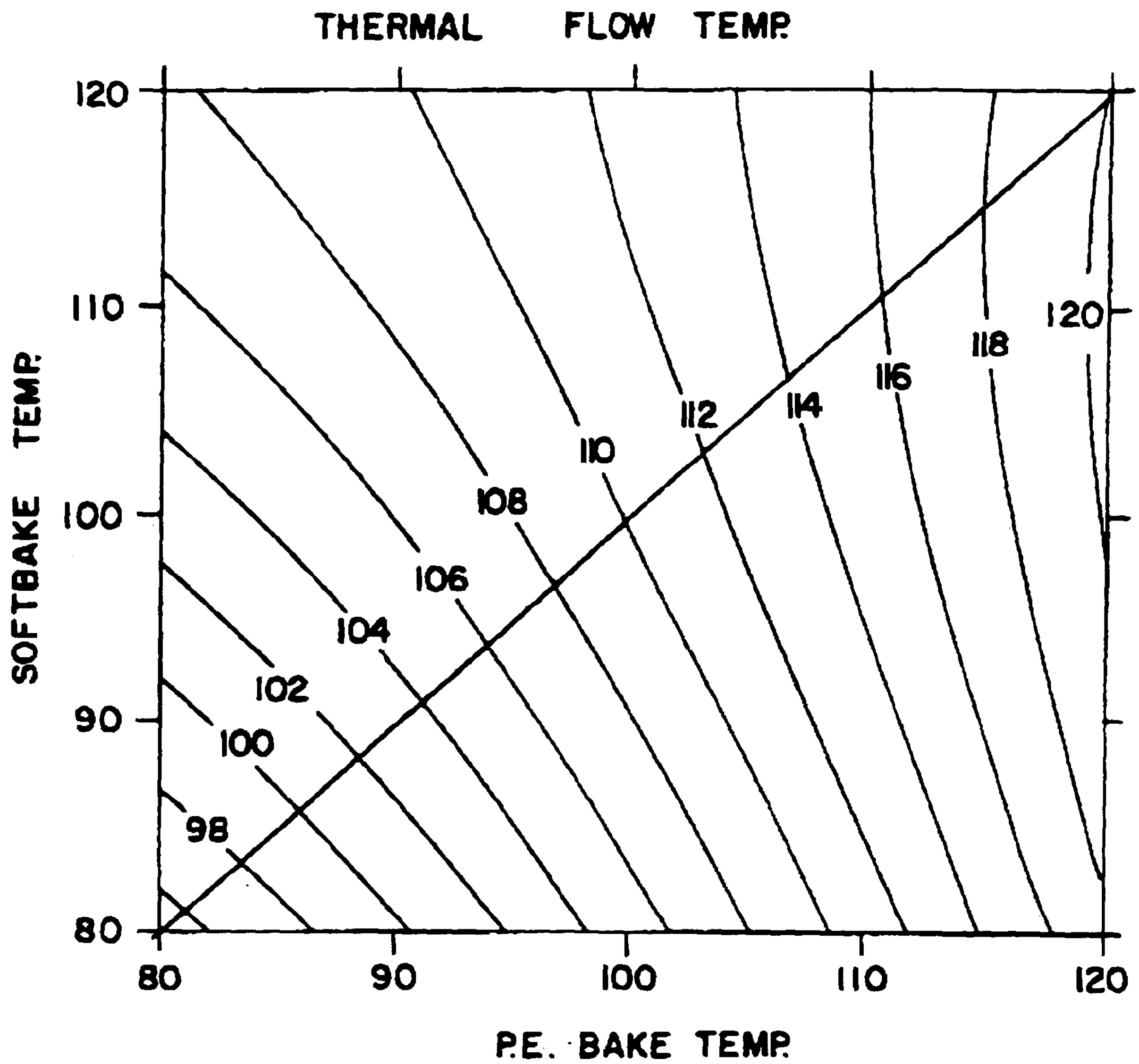
THERMAL FLOW TEMP.
SOFTBAKE TEMP.
P.E. BAKE TEMP.
80
90
100
110
120
98
100
102
104
106
108
110
112
114
116
118
120

FIG. 9

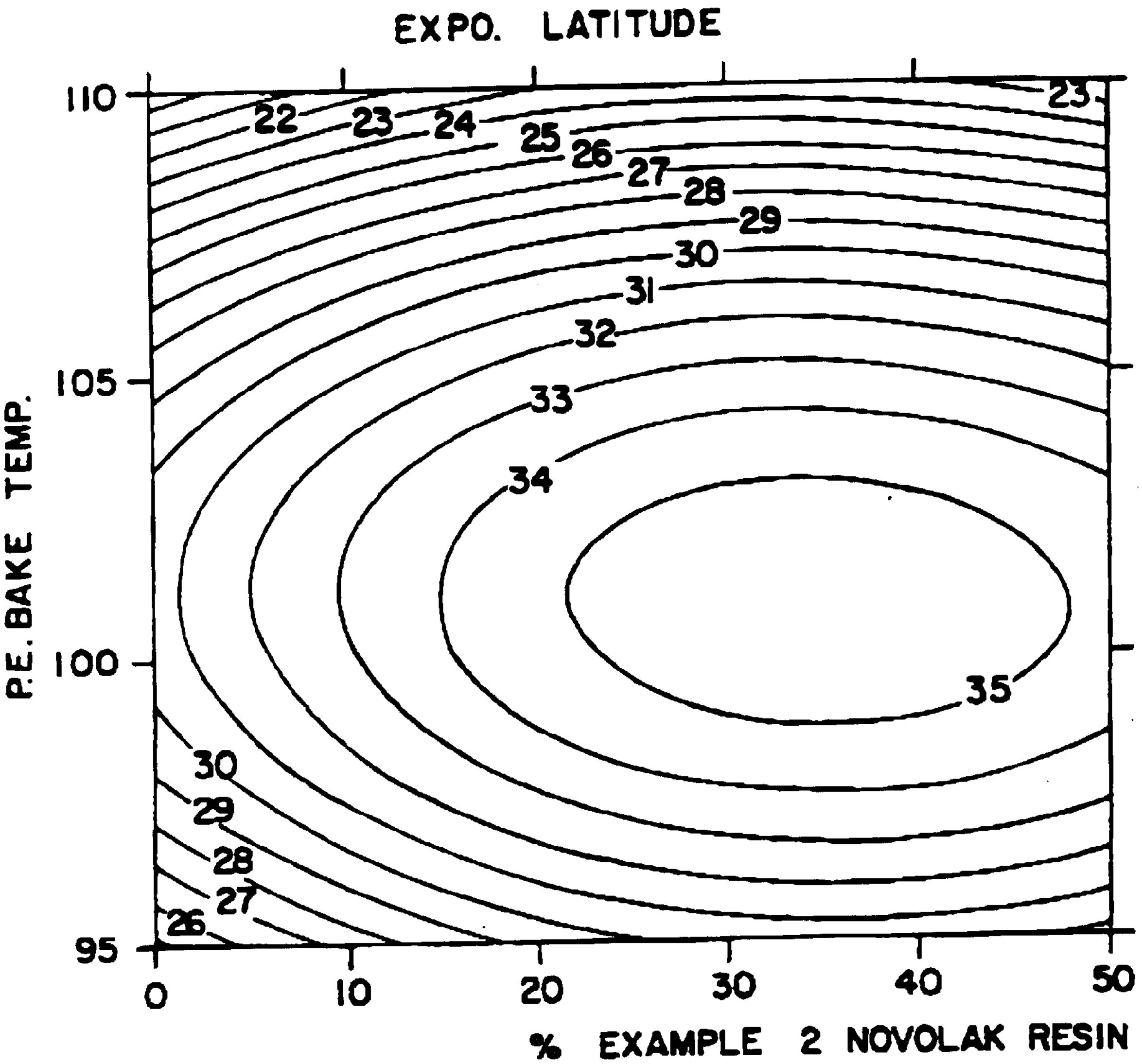
EXPO. LATITUDE
P.E. BAKE TEMP.
110
105
100
95
0
10
20
30
40
50
% EXAMPLE 2 NOVOLAK RESIN
22
23
24
25
26
27
28
29
30
31
32
33
34
35
23
30
29
28
27
26

FIG. 10

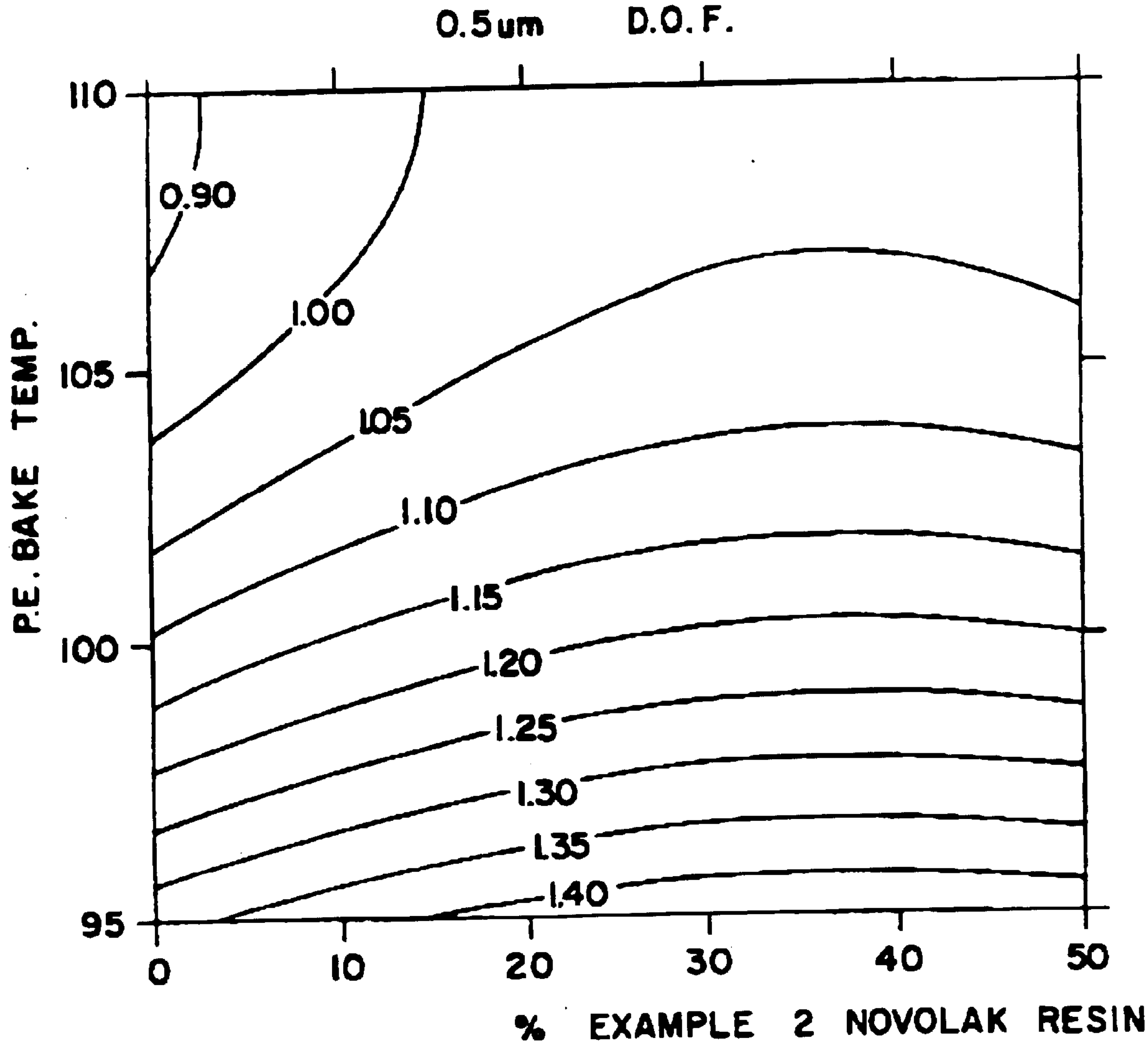
0.5um D.O.F.
110
105
100
95
P.E. BAKE TEMP.
0.90
1.00
1.05
1.10
1.15
1.20
1.25
1.30
1.35
1.40
0
10
20
30
40
50
% EXAMPLE 2 NOVOLAK RESIN